# EUROPÄISCHE PATENTSCHRIFT

(11) **EP 1 141 746 B1**
(45) Veröffentlichungstag und Bekanntmachung des Hinweises auf die Patenterteilung: **11.06.2003**
(21) Anmeldenummer: 99967894.9
(22) Anmeldetag: 22.12.1999
(51) Int. Cl.: G01S 13/02, G06K 19/067

(54) **FUNKABFRAGBARES OBERFLÄCHENWELLEN-BAUELEMENT MIT OPTIMALEM CODEUMFANG**
REMOTE-INQUIRY SURFACE ACOUSTIC WAVE COMPONENT WITH OPTIMUM CODE SPACE
COMPOSANT A ONDES DE SURFACE INTERROGEABLE A DISTANCE ET AYANT UN ECARTEMENT CODE OPTIMAL

(30) Priorität: 23.12.1998 DE 19860058
(43) Veröffentlichungstag der Anmeldung: 10.10.2001
(73) Patentinhaber: SIEMENS AKTIENGESELLSCHAFT, 80333 München (DE)
(72) Erfinder: VOSSIEK, Martin, D-80789 München (DE); SCHMIDT, Frank, D-85604 Pöring (DE); SCZESNY, Oliver, D-85609 Aschheim (DE); REINDL, Leonhard, D-83071 Stephanskirchen (DE)
(86) Internationale Anmeldenummer: DE9904079
(87) Internationale Veröffentlichungsnummer: WO00039604

(56) Entgegenhaltungen:
- WO-A-97/26555
- US-A- 4 737 790
- REINDL L ET AL: "PROGRAMMABLE REFLECTORS FOR SAW-ID-TAGS" PROCEEDINGS OF THE ULTRASONICS SYMPOSIUM,US,NEW YORK, IEEE,1993, Seiten 125-130, XP000473552 ISBN: 0-7803-1279-1

## Beschreibung

Die vorliegende Erfindung bezieht sich auf ein funkabfragbares kodiertes Oberflächenwellen-Bauelement, wie es prinzipiell aus dem Stand der Technik (US-A-4 263 595, US-A-5 469 170, 1995 IEEE Ultrasonics Symp., S. 117-120, WO 96/14589, WO 97/42519, WO 97/26555) bekannt ist.

Ein Oberflächenwellen-Bauelement umfaßt bezüglich seines konstruktiven Aufbaues ein Substratplättchen aus einem piezoelektrischen oder piezoelektrisch beschichteten Material. Auf bzw. in dessen Oberfläche/Schicht mit dieser piezoelektrischen Eigenschaft ist wenigstens eine Interdigitalstruktur als ein piezoelektrischer Wandler angeordnet. Mittels dieses Wandlers läßt sich bei entsprechender elektrischer Anregung der Strukturelemente des Wandlers in der Oberfläche des Substrats eine allgemein als Oberflächenwelle bezeichnete akustische Welle erzeugen. Diese hat dort eine Verlaufsrichtung/-form, die bekanntermaßen durch die Interdigitalstruktur bestimmt ist. Eine solche Struktur bestimmt eine Haupt-Wellenausbreitungsrichtung in der Ebene der Oberfläche.

Entsprechend einem funkabfragbaren Oberflächenwellen-Bauelement läßt sich die erwähnte Oberflächenwelle in dem Bauelement durch auf dem Funkweg vorgenommene Erregung/Speisung des Wandlers anregen. Dazu ist der Wandler mit einer entsprechenden Antenne für den Funkempfang und in der Regel auch für die funkmäßige Rücksendung eines Antwortsignals von diesem Wandler zu einem Empfänger ausgestattet. Für das Abfragesignal kann auch ein gesonderter Wandler mit Antenne vorgesehen sein.

Das Abfragesignal wird mittels eines Senders ausgesandt, der mit vorzugebender Mindestbandbreite auszusenden vermag. Für diese Funksignal-Aussendung kann z.B. eine Vorrichtung verwendet werden, die aus thermischer und/oder mechanischer Energie mit Hilfe z.B. eines nicht-linearen elektronischen Bauelements wie einer Funkenstrecke einen Hochfrequenz- Impuls zu erzeugen vermag. Einzelheiten hierzu sind bekannt.

Der für das vom erwähnten Bauelement zurückgesandte Funk-Antwortsignal vorgesehene Empfänger ist insbesondere bezüglich seiner Bandbreite den Vorgaben des mit dem Oberflächenwellen-Bauelement arbeitenden Systems wie bekannt zu bemessen.

Bei Oberflächenwellen-Bauelementen, die zur Identifikation verwendet werden, ist gefordert, daß sichergestellt ist, daß ein empfangenes Signal als Antwortsignal einem vorgegeben und dafür entsprechend individuell codierten Oberflächenwellen-Bauelement eindeutig zugeordnet werden kann, sei es daß ein System eine Mehrzahl solcher jedoch voneinander unterschiedlich codierter abzufragender Bauelemente umfaßt und/oder sei es, daß sonstige Signale empfangen werden, die sonstwie in den Empfänger des Systems gelangen.

Bekannte und übliche Praxis ist es, solche funkabfragbaren Oberflächenwellen-Bauelemente also mit einer jeweils individuellen Codierung zu versehen, die das einzelne Bauelement innerhalb einer Vielzahl solcher im System enthaltener Oberflächenwellen Bauelemente im jeweiligen Empfangssignal voneinander eindeutig unterscheidbar macht.

Zum Voranstehenden seien aus den Anwendungsmöglichkeiten für solche funkabfragebare codierte Oberflächenwellen-Bauelemente zwei Beispiele genannt. Das eine dieser Beispiele ist, daß ein solches Oberflächenwellen-Bauelement mit Codierung an z.B. einem Gegenstand angebracht ist, der mittels dieses Bauelements bzw. seiner Codierung entsprechend zu identifizieren ist. Solche Bauelemente sind auch als ID-Tags bekannt. Ein anderes Beispiel ist, daß das Oberflächenwellen-Bauelement die zusätzliche Eigenschaft hat bzw. mit einer solchen ausgerüstet ist, als Sensor für z.B. das Messen einer Temperatur, einer Kraftgröße und/oder anderer physikalischer, chemischer und dgl. Zustandsgrößen zu dienen. Solche Anwendungen und dazu diesbezügliche Ausgestaltungen eines Oberflächenwellen-Bauelementes sind bekannt.

Es sind verschiedene Prinzipien möglich, aus einem Abfragesignal ein codiertes Funk-Antwortsignal zu erzeugen. Ein Beispiel ist, für die Codierung Reflektorelemente vorzusehen, die auf die Anordnung der schon erwähnten Interdigitalstruktur des Wandlers in bekannter Weise abgestimmt angeordnet sind. Solche Reflektorelemente sind im Regelfall Streifenelemente, die im Weg der Haupt-Wellenausbreitungs-richtung der Oberflächenwelle auf/in der Oberfläche des Substratplättchens vorgesehen sind. Es können anstelle solcher genannter Reflektorelemente als weiteres Beispiel für Codeelemente auch Resonatoren dem oder den Wandler(n) zugeordnet sein, wie dies auch noch weiter unten beschrieben ist.

Ein einzelnes Reflektorelement bewirkt ein zum Abfragesignal, d.h. zum Sendeimpuls zeitverschobenes Antwortsignal des Oberflächenwellen-Bauelements. Ein statt dessen mit Resonatoren versehenes Bauelement ergibt ein entsprechend (resonanz-) frequenzen-bestimmtes Antwortsignal. Eine jeweilige Vielzahl von in verschiedenen Positionen (zueinander bzw. bezogen auf den Wandler) angeordneten Reflektoren ergibt eine entsprechende Vielzahl von unterschiedlich zeitverschobenen Impuls-Antwortsignalen, wobei die Zeitverschiebungen untereinander abhängig sind von den Positionen der betreffenden Reflektoren zueinander. Entsprechendes gilt für eine jeweilige Anzahl von frequenzmäßig verschiedenen vorgesehenen Resonatoren hinsichtlich verschiedener Antwort-Resonanzfrequenzen.

Das vom Oberflächenwellen-Bauelement auf ein Funk-Abfragesignal zu erhaltende Antwortsignal ist also im Falle der Reflektoren eine additive Überlagerung aus zeitlich gegeneinander versetzten Antwort-Teilsignalen bzw. im Falle der Resonatoren eine additive Überlagerung aus entsprechend vielen sinusförmigen, zeitbegrenzten (zumeist exponentiell abklingenden) Antwort-Teilsignalen mit voneinander verschiedenen Frequenzen. Die Identifikation eines jeweiligen Oberflächenwellen-Bauelements erfolgt üblicherweise derart, daß die Empfangszeitpunkte, die den ausgewählten Positionen der einzelnen Reflektoren des betreffenden Bauelements entsprechend bestimmt werden. Mit dem Resonatorenprinzip ergeben sich Amplituden des Empfangsspektrums an Frequenzstützpunkten, die den ausgewählten Resonanzfrequenzen der einzelnen Resonatoren entsprechen. Die Codierung bzw. der eingeprägte Code eines betreffenden Reflektor-codierten Oberflächenwellen-Bauelements besteht also gegenständlich/konstruktiv in einer codierten Positionierung der einzelnen vorgesehenen Reflektoren in Bezug auf ein Referenz-Reflektorelement bzw. in Bezug auf die Position des Wandlers auf der Oberfläche des Substratplättchens. Für den Fall der Codierung mit Resonatoren ergeben die ausgewählt vorgegeben verschiedenen Resonanzfrequenzen der einzelnen Resonatoren den dem jeweiligen Bauelement eingeprägten Code.

Ein damit verbundenes Problem ist, daß die Strukturauflösung des zugehörigen Meßsystems stets begrenzt ist. Unter Strukturauflösung wird hier die Fähigkeit des Systems (hier im wesentlichen bestehend aus dem Sender, dem Oberflächenwellen-Bauelement und dem Empfänger) verstanden, zwei Reflexions- bzw. Resonanz-Antwort-Teilsignale zweier auf dem Substratplättchen unmittelbar benachbart angeordneter Reflektoren bzw. zweier Resonatoren mit unmittelbar benachbarten Resonanzfrequenzen jeweils als zwei voneinander separierte Antwort-Teilsignale zu erkennen. Bei Systemen mit Zeitmessung (Reflektoren) ist die zeitliche Strukturauflösung Δt umgekehrt proportional zur verwendeten spektralen Bandbreite B des Systems/der Messung also Δt prop. 1/B. Beim System mit Frequenzmessungen (Resonatoren) sind die Verhaltnisse im Prinzip analog, d.h. daß hier die Strukturauflösung Δf durch die Güte des Systems, d.h. umgekehrt proportional zur zeitlichen Dauer t der Meßsignale ist (Δf prop. 1/t). Der Proportionalitätsfaktor beträgt bei üblichen Meßsignalen mit einer Gauss-förmigen Einhüllenden ca. 0,5.

Die erwähnte, prinzipiell begrenzte Strukturauflösung hat zur Folge, daß alle Codeelemente bei Reflektoren einen Mindestabstand voneinander aufweisen müssen und bei Resonatoren einen entsprechenden Mindest-Frequenz-Mittenabstand haben müssen, da sich sonst im Antwortsignal die Signalanteile von positions- bzw. frequenz-benachbarten Elementen (Reflektoren oder Resonatoren) derart überlagern würden, daß eine sichere Auswertung (Identifikation) eines Codes eines betreffenden Bauelements nicht mehr möglich wäre.

Lediglich der Vollständigkeit halber sei darauf hingewiesen, daß bei der noch nachfolgend zu beschreibenden Erfindung zusätzlich auch noch weitergehende Codierungs-Möglichkeiten vorgesehen sein können. Zum Beispiel kann anstelle eines binären Systems (Reflektor vorhanden/Reflektor nicht vorhanden) auch Codes mit einer höheren Basis als 2 angewendet werden. Eine Möglichkeit hierzu ist, mehrere Amplitudenschwellen-/stufen für ein jeweiliges Codeelement vorzusehen. Eine andere Möglichkeit besteht darin, (in Stufen) die Phasendifferenz zwischen zwei Signalen zweier Codeelemente (zusätzlich) auszuwerten.

Die bekannte Art der Codierung ist, je nach gefordertem Codeumfang mehr oder weniger viele Reflektorstreifen auf dem Oberflächenwellen-Bauelement entlang der Haupt-Wellenausbreitungsrichtung der vom Wandler erzeugten Oberflächenwelle positionsmäßig verteilt anzuordnen. Für z.B. einen Codeumfang von 32 Bits ist es als Stand der Technik bekannt, 32 in Richtung der Haupt-Wellenausbreitungsrichtung hintereinander liegende Plätze für bis zu 32 zu setzende Reflektoren vorzusehen. Bei einer (im Maß der Laufzeit = Wegläng s geteilt durch die Geschwindigkeit v der akustischen Welle gemessen) Strukturauflösung des Systems von 1 µs benötigt man also für die duale Codierung für die Anordnung der Reflektoren eine Laufzeitlänge von 31 µs, nämlich vom ersten bis zum 32. Bit. Dies bedingt eine beträchtliche Länge des für das Bauelement erforderlichen Substratplättchens. Damit verbunden sind technische Probleme, die noch nachfolgend im Zusammenhang mit der Erfindung erörtert werden. Bezüglich der Verwendung von Resonatoren als Codeelemente siehe auch die (weiter unten) gegebene Detailbeschreibung.

Aufgabe der vorliegenden Erfindung ist es, für einen vorgegebenen insbesondere hohen Codeumfang mit (zum Stand der Technik vergleichsweise) kleinerer Substratplättchenlänge/-größe und/oder möglichst wenigen Codeelementen je einzelnem Code auszukommen. Mit anderen Worten heißt dies, es ist ein Codierungsschema für einen vorgegebenen Codeumfang gesucht, das mit optimal wenigen Codeelementen je Code auskommt, die zudem auf einer geringeren Substratplättchenlänge/-fläche individuell ausgewählt angeordnet sind.

Diese Aufgabe wird mit den Maßnahmen des Patentanspruches 1 bzw. 2 gelöst und weitere Ausgestaltungen und Weiterbildungen der Erfindung gehen aus den Unteransprüchen hervor.

Für das erfindungsgemäße neue Codierungsprinzip ist eine neuartige, die jeweiligen Codes bildende Positionen- bzw. Frequenzen-Verteilung vorgesehen, die (hier zunächst für den Fall der Positionenverteilung von Reflektoren nachfolgend erläutert) bei gegebener, oben definierter Strukturauflösung eine höhere Anzahl verschiedener Codes ermöglicht. Um beim o.g. Beispiel zu bleiben, erbringt die Erfindung bei einer Strukturauflösung von z.B. 1 µs des Oberflächenwellen-Bauelements und seines zugehörigen Systems (insbesondere des signalauswertenden Empfängers) auf der o.g. Länge von 31 µs Laufzeit der akustischen Welle statt wie im Stand der Technik 2³² zur Verfügung stehenden unterschiedlichen Codierungen rund 4000-fach vergrößerten Codeumfang (17 167 680 177 565 Codierungen), was in etwa einem Codeumfang von 43 Bit nach bekannter Codierung entspricht. Um den obigen Codeumfang der 32 Bit stattdessen mit der nachfolgend angegebenen erfindungsgemäßen Maßnahme setzen zu können, bedarf es bei der Erfindung jeweils nur 23 gesetzter Reflektoren (Resonatoren) für jeden einzelnen der Codes, für die dann die wesentlich geringere Substratplättchenlänge entsprechend 22,5 µs Laufzeit ausreicht. Der voranstehende Zahlenvergleich ist lediglich ein Beispiel des mit der Erfindung zu erreichenden Vorteils. Dieser kann bei angenommen noch kleinerer Meßungenauigkeit der Laufzeitmessung bei Reflektoren (bzw. der Frequenzmessung bei Resonatoren) in dem System sogar noch vielfach größer gewählt werden, so daß z.B. die bekannte 32-Bit-Codierung mit jeweils nur maximal 20 gesetzten Reflektoren je Code dann sogar auf 19 µs Länge generierbar ist.

Nunmehr werden weitere Erläuterungen in erster Linie zu und anhand der Ausführung eines erfindungsgemäßen Bauelements mit Reflektoren (= Codierung im Zeitbereich) gegeben und weiter unten folgen noch zusätzliche Hinweise zur Ausführung mit Resonatoren (= Codierung im Frequenzbereich).

Anspruchsgemäß wurde zur bekannten, oben definierten Strukturauflösung Δ die Eigenschaft der Meßungenauigkeit δ des Systems für Laufzeitmessung bzw. Frequenzmessung hinzugezogen bzw. hier eingeführt. Die Meßungenauigkeit bezeichnet den stochastischen und systematischen Fehler, mit dem der mit dem System gemessene Laufzeit-/Frequenz-Wert vom tatsächlichen Laufzeit-/Frequenz-Wert der physikalischen Struktur abweicht. Die Zeitposition eines Reflektors bzw. die Frequenz eines Resonators kann aufgrund der Ungenauigkeit der in bzw. mit dem System durchgeführten Messung nur auf ein durch die Meßungenauigkeit bezeichnetes Intervall genau bestimmt werden. Das Maß der Meßungenauigkeit δ ist bei Systemen mit Oberflächenwellen-Bauteil in aller Regel deutlich kleiner als das Maß der Strukturauflösung. Die Meßungenauigkeit kann bei stochastischen Meßfehlern durch Mittelung mehrerer Messungen oder bei systematischen Fehlern durch Kalibrierungsvorgänge auch noch weiter verringert werden, worauf weiter unten noch eingegangen wird..

Erfindungsgemäß wird mit diesem δ-Maß das jeweilige Positionenraster mit äquidistanten Rasterabständen δt bzw. das Frequenzen-Raster mit frequenzgleichen Rasterabständen δf für die Codierung entsprechend der Lehre der Erfindung gebildet.

Das Prinzip der Erfindung ist, trotz durch die Bandbreite gegeben z.B. weiterhin gleichbleibend groß verfügbarer Strukturauflösung Δ, diese Reflektoren erfindungsgemäß in einem solchen Positionenraster anzuordnen und, um die Position eines jeweiligen Reflektors trotz der begrenzten Strukturauflösung eindeutig bestimmen zu können, vorzusehen, daß in einem Positionenraster die Rasterplätze nur derart besetzt sind, daß bei keinem Code, d.h. bei keiner Codekonfiguration, miteinander benachbarte Plätze des Positionsrasters besetzt sind. Ist z.B. die Meßungenauigkeit der Laufzeitmessung im Zeitmaß gemessen halb so groß (z.B.δt = 0,5 µs) wie die ebenfalls im Zeitmaß gemessene Strukturauflösung Δ (z.B. 1 µs) so sieht die erfindungsgemäße Regel vor, zwischen zwei besetzten Plätzen des Positionenrasters mindestens einen Platz des Rasters unbesetzt zu lassen. Ist z.B. das Maß δt sogar nur 1/3 so groß wie die Strukturauflösung, ist das Positionenraster dreimal so fein geteilt wie sich ein Raster mit dem Maß der Strukturauflösung ergäbe. Der erfindungsgemäßen Regel nach müssen dann zwar mindestens zwei Plätze des Positionenrasters zwischen zwei benachbarten gesetzten Reflektoren des Codes unbesetzt bleiben, nämlich wiederum bedingt durch die begrenzte Strukturauflösung, jedoch steigt dann dennoch der Codeumfang des erfindungsgemäßen Prinzips mit für den einzelnen Code beispielsweise 32 gesetzten Reflektorpositionen auf 5 x 10¹⁵ Codierungen. Der Codeumfang der obigen 32-Bit-Codierung wäre in diesem Falle mit je Code nur noch maximal 20 gesetzten Reflektoren auf einer Chip-Länge von nur noch 19 µs generierbar.

Die voranstehenden Ausführungen gelten für die Erfindung sinngemäß auch für Resonatoren als Codeelemente anstelle der genannten Reflektoren, was weiter unten noch näher erläutert wird..

Gemäß einer Weiterbildung der Erfindung ist vorgesehen, für die einzelnen Codes/(Codierungsmöglichkeiten) der einzelnen individuellen Bauelemente innerhalb der Gruppe von Bauelementen eines vorgegebenen gesamten Codeumfangs stets einheitlich gleich viele Codeelemente, d.h. Reflektoren bzw. Resonatoren, im jedem einzelnen der Bauelemente vorzusehen. Für das Oberflächenwellen-Bauelement bedeutet dies, daß vom Wandler aus gesehen und für die Ausbreitung der akustischen Welle gültig stets gleichbleibend große Dämpfung der Welle vorliegt und die Erkennung eines fehlerhaften Codes aus einer abweichenden Anzahl der empfangenen Teilsignale folgt. Gemäß dieser Weiterbildung der Erfindung mit konstanter Codeelemente-Anzahl sind diese Codeelemente für die jeweiligen Codes nur unterschiedlich verteilt im Positionenraster angeordnet. Das ganze Positionenraster hat einheitlich - vergleichsweise zum Stand der Technik - optimal kurze Länge bzw. es ist eine kurze Bauelement-Abmessung ermöglicht.

Bei noch geringerer Meßungenauigkeit (z.B. als die voranstehend erwähnten 0,33 µs) kann der Codeumfang bzw. die Anzahl der Codierungsmöglichkeiten mit einer vorgegebenen Anzahl Codeelemente je Code bei Reflektoren für eine vorgegebene Länge bzw. für Resonatoren auf einer vorgegebenen Fläche des Bauelementchips noch weiter vergrößert werden. Umgekehrt kann bei noch weiter verringerter Meßungenauigkeit bei vorgegebenem Codeumfang die je Code erforderliche Anzahl von Codeelementen und/oder die erforderliche Länge bzw. Fläche des Substratplättchens des Bauelements verringert werden.

Mit anderen Worten gesagt, läßt sich der Erfindungsgedanke auch wie folgt beschreiben:

Für die Codeelemente der einzelnen Codes des Codeumfangs wird ein erfindungsgemäßes Raster gebildet. Für Reflektoren ist dies ein Positionenraster und für Resonatoren als Codeelemente ein Frequenzen-Raster. Das betreffende Raster hat äquidistante (Positionen- oder Frequenzen-)Grundabstände δg der Raster-Grundwerte voneinander.

Diese Abstände bemessen sich nach der Meßungenauigkeit des Systems, in dem mit einem Fehler δ (δt für Laufzeitmessung; δf für Frequenzmessung) eine Laufzeit bzw. eine Frequenz gemessen werden kann.

In einem erfindungsgemäßen Raster werden diese Abstände optimal gleich groß wie oder auch größer als dieses Maß δ bemessen.

Es werden erfindungsgemäß aber jeweils nur jene Grundwerte (Positionen/Frequenzen) mit Codeelementen "besetzt", bei denen die Abstände zwischen derart positionierten Codeelementen gleich sind wie oder größer sind als die Strukturauflösung Δ des gesamten Systems. Beträgt die Meßungenauigkeit δ = 0,5 µs oder 0,33 µs sind diese erfindungsgemäß geforderten Abstände Δ zwischen positionierten Reflektoren als Codeelementen bei einer Strukturauflösung von 1 µs im Zeitmaß gemessen jeweils 1 µs. Der wesentliche Unterschied gegenüber dem Stand der Technik ist, daß durch Nutzung der gegenüber der Strukturauflösung dem Maß nach geringeren ein entsprechend mehrfach feineres Positionenraster für die Besetzung mit Reflektoren als Codeelementen zur Verfügung steht. Bei unveränderter Strukturauflösung Δ kann man dadurch mit gleichbleibender Anzahl Codeelemente je Code einen größeren Codeumfang oder den bisherigen Codeumfang mit weniger Codeelementen je Code erreichen. Das Teilungsverhältnis von Strukturauflösung zu gewähltem Rastermaß kann auch (größer 1) nicht-ganzzahlig sein.

Wendet man diese Lehre zum technischen Handeln auf mit Resonatoren codierte Oberflächenwellen-Bauelemente an, ergibt sich folgende Analogie. Anstelle von R Reflektoren ist die Anzahl R Resonatoren auf dem Substratplättchen des jeweiligen Oberflächenwellen-Bauelements (das zu dem vorgegebenen Codeumfang gehört) vorgesehen und angeordnet. Diese R Resonatoren haben voneinander jeweils verschiedene Resonanzfrequenzen fᵢ mit i = 1 bis R. Das Raster für die Auswahl dieser Frequenzen fᵢ ist das erfindungsgemäße Frequenzen-Raster mit seinen Grundwerten f, z.B. 1 bis 46. Diese haben äquidistanten Abstand δf. Dieser Grundabstand der für die Codierung (unter einer noch nachfolgend angegebenen Beschränkung) zur Verfügung stehenden Resonanzfrequenzen ist derart bemessen, daß er größer als oder optimalerweise gleich dem Maß der Meßungenauigkeit δf ist, mit der man in dem System, bestehend aus dem Sender, dem Empfänger und dem Bauelement, eine einzelne Frequenz messen kann. Vergleichsweise zum Falle der Reflektoren dürfen auch hier aus den (z.B. 1 bis 46) Grundwerte-Frequenzen des Rasters erfindungsgemäß innerhalb des Rasters nur solche Resonanzfrequenzen fᵢ für als Codeelemente zu verwendende Resonatoren ausgewählt werden, bei denen die Abstände benachbarter ausgewählter Resonanzfrequenzen (fⱼ, fⱼ₊₁) zweier Resonatoren jeweils größer ist als oder optimal gleich groß ist wie die Strukturauflösung, d.h. die Frequenzauflösung Δf des gesamten Systems, eingeschlossen die natürliche Bandbreite dieser Resonatoren, die sich aus ihrer Güte ergibt.

Zur Berechnung des Codeumfangs kann man folgendes Berechnungsgesetz verwenden. Es sei P die Anzahl der Grundwerte pro Intervall der Strukturauflösung Δ (p · δ = Δ) Zum Beispiel ist P = 2 für das genannte Beispiel mit 0,5 µs Meßungenauigkeit und 1 µs Strukturauflösung. P = 3 gilt für das genannte Beispiel mit 0,33 µs Meßungenauigkeit bei wiederum 1 µs Strukturauflösung. Gegeben sei der Codeumfang Cu für die Anzahl R der jeweiligen Codeelemente (also Cu{R}) und für die Anzahl Codeelemente R + P - 1 (Cu{R +P-1}). Der Codeumfang (Cu{R +P}) ergibt sich dann aus der Summe, d.h. es gilt (Cu{R +P}= (Cu{R }+(Cu{R +P-1}). Ist folglich der Codeumfang für P aufeinanderfolgende Codeelementeanzahl (Cu{R}), (Cu{R +1}), ... (Cu{R +P-1}) bekannt, so kann der Codeumfang für alle folgenden Codeelementanzahlen sukzessive berechnet werden.

Der Codeumfang kann auch für den Fall von Resonatoren als Codeelemente noch weiter erhöht werden, wenn die Empfangseinheit zusätzlich so ausgebildet ist, daß sie Amplitude und/oder Phase oder Frequenzlage der empfangenen Teilsignale der einzelnen Codeelement-Resonatoren zu bestimmen gestattet. In diesem Fall kann die Amplitude oder die Phase oder es können auch beide Informationen zusätzlich nach wiederum an sich bekanntem Prinzip zur zusätzlichen Erweiterung des Codeumfangs genutzt werden.

Soll die Struktur der Codeelemente außerdem auch für sensorische Meßzwecke (wie oben schon erwähnt) eingesetzt werden, so kann es auch vorteilhaft sein, die möglichen Positionen der Reflektoren bzw. Frequenzen der Resonatoren nicht exakt in dem erfindungsgemäßen äquidistanten Raster anzuordnen, sondern definierte Abweichungen der Codeelement-Position (-Frequenzen) einzuführen, so daß die Abstände/Frequenzabstände zwischen den Codeelementen nicht exakt gleich dem äquidistanten Raster sind. So wird verhindert, daß alle Reflektoren bzw. Resonatoren redundant sensorisch Informationen liefern. Bei dieser Art der Ausführung ist natürlich nach wie vor dafür Sorge zu tragen, daß alle positionsmäßigen bzw. frequenzmäßigen Abstände zwischen Codeelementen erfindungsgemäß wenigstens nicht kleiner sind als es die Strukturauflösung Δ (oben z.B. 1 µs) des gesamten Sensorsystems ist. Hierzu kann entweder der Grundabstand δ dann größer (als minimal) bemessen sein oder es können weniger Codes vorgesehen sein.

Die erfindungsgemäße Art der Codierung eines Oberflächenwellen-Bauelements bietet u.a. mehrere nachfolgend beschriebene Vorteile, z.B. auch hinsichtlich der technischen Realisierung und Ausführung am Oberflächenwellen-Bauelement. Die erfindungsgemäße Art der Codierung ist z.B. im Gegensatz zu einer Mehrphasencodierung in Grenzen wenig abhängig von Änderungen der Fortpflanzungsgeschwindigkeit der Oberflächenwelle in dem Bauelement. Zum Vergleich sei z.B. ein ID-Tag mit der Mittenfrequenz 434 MHz, einer Strukturauflösung 1 µs und mit einer Anzahl P = 4 Reflektoren pro Intervall Δ herangezogen. In diesem Falle besitzt eine 4-stufige Phasencodierung (4 PSK Modulation) vergleichbaren Codeumfang wie die erfindungsgemäß ausgeführte Codierung, die als Puls-Positionsmodulation zu bezeichnen ist. Die minimale Strukturauflösung mit 1 us beträgt bei dieser Mittenfrequenz 434 x λ. Bei der bekannten 4 PSK-Modulation sind zwei benachbarte Zustände durch 90° Phase, d.h. ¼ λ getrennt. Eine Variation der zeitlichen Lage eines Reflektors um nur 0,25 λ : 434 λ = 1 µs : 1736, z.B. hervorgerufen durch eine Positionsungenauigkeit bei der Herstellung des Bauelements oder infolge einer Abweichung der Geschwindigkeit der Oberflächenwelle des Bauelements, führt somit bereits zu einer nicht tolerierbaren Verfälschung des Antwortsignals und damit zu fehlerhafter Identifizierung. Bei einem Bauelement mit wie erfindungsgemäßer Codierung würde ein derartiger Fehler erst dann eintreten, wenn die Position eines Reflektors innerhalb des Rasters um 0,25 µs fehlerhaft positioniert wäre. Erst dann würde bei einem Oberflächenwellen-Bauelement nach der Erfindung codiert eine vergleichbare Verfälschung des Signals eintreten. Dies zeigt, daß ein Oberflächenwellen-Bauelement mit nach der Erfindung ausgeführter Codierung somit um den Faktor 400 unempfindlicher ist gegenüber Schwankungen der Oberflächenwellen-Geschwindigkeit und/oder Positionierungsfehlern, vergleichbar mit der bekannten PSK-Modulation. Dies zeigt im übrigen auch, daß die erfindungsgemäße Art der Codierung eine äußerst robuste mehrwertige Codierung eines Oberflächenwellen-Bauelements ist. Damit verbunden sind große Vorteile, die auch die Herstellung eines jeweiligen, nach der Erfindung codierten Bauelements betreffen.

Voranstehend ist für die Rasterabstände δt bzw. δf des erfindungsgemäßen/erfindungsgemäß verwendeten Positionen-Rasters/Frequenzen-Rasters ein jeweiliges Maß δ für die Meß-ungenauigkeit zugrundegelegt, das mehr oder weniger kleiner ist als die Strukturauflösung Δ des Systems. Dabei ist dieses Maß des Wertes δ z.B. auf Erfahrungen bzw. Messungen beruhend gewählt, die mit dem Arbeiten mit Oberflächenwellen-Elementen gewonnen worden sind. Aufgabe einer Weiterbildung der Erfindung ist, Maßnahmen anzugeben, mit denen ein zu erreichendes (kleines) Maß der Meßungenauigkeit δ vorgebbar gezielt zu erreichen ist, nämlich um die oben beschriebene Erfindung möglichst optimal nutzen zu können.

Diese Aufgabe wird mit einer vorteilhaften Art der Durchführung des Auslesens eines jeweiligen Codes eines jeweiligen codierten Oberflächenwellen-Bauelements gelöst. Diese Durchführung des Auslesens sieht ein aufeinanderfolgend mehrfaches Auslesen des jeweiligen Codes, d.h. ein entsprechend mehrfaches Messen der jeweiligen einzelnen Codeelemente vor. Es wird also das Zeitmaß t der Position des jeweilig einzelnen Reflektors bzw. die Frequenz des jeweils einzelnen Resonators mittels des Abfragesignals meßtechnisch erfaßt, d.h. gemessen. Dieses mehrfache Auslesen der einzelnen Codeelemente des jeweiligen Codes wird im Verlauf des entsprechend mehrfachen Auslesens dieses Codes in einer äußerst raschen Aufeinanderfolge vorgenommen. Man erhält damit Datensätze, die die mehrfachen Meßergebnisse des jeweils einzelnen Codeelementes umfassen. Für jedes Codeelement des ausgelesenen Codes erhält man einen gleichartigen Datensatz. Diese Datensätze werden analysiert und man erhält das Maß der Standardabweichung bzw. ein anderes Maß, das die Statistik bzw. die Ungenauigkeit der Einzelmessungen innerhalb des jeweiligen Datensatzes beschreibt. Mit entsprechender Häufigkeit der Messungen erhält man einen jeweiligen Mittelwert (für die Reflektorposition bzw. für die Resonanzfrequenz des Resonators) oder auch einen anderweitigen repräsentativen Positions-/Frequenzmittelwert mit einer Meßungenauigkeit, die als für die erfindungsgemäß definierte und verwendete Meßungenauigkeit δ zugrundegelegt werden kann.

Hat man mit dem obigen mehrfachen Auslesen der Codeelemente eines jeweiligen Codes eine z.B. vorgegebene Meßungenauigkeit δ, d.h. ein vorgegebenes Rastermaß δ t bzw. δ f sogar um ein Maß unterschritten, so ist die Wahrscheinlichkeit erhöht, daß das jeweilige Codeelement, d.h. die Reflektorposition/Resonanzfrequenz, korrekt gemessen ist, d.h. der ganze ausgelesene Code richtig ausgelesen worden ist. Durch diese Weiterbildung betreffend die Durchführung des Auslesens mit mehrfachem Auslesen und Mittelung wird eine Auswertung erreicht, in der alle stochastischen Ungenauigkeiten, die einer jeglichen Messung inherent sind, auf ein (ausreichend) geringes Maß reduziert sind.

In zur voranstehenden beschriebenen Mittelung der Meßwerte kann in damit vergleichbarer Weise auch eine Kalibrierung zur Beseitigung etwaiger systematischer Fehler durchgeführt werden. Hierzu ist es erforderlich, daß das Oberflächenwellen-Bauelement mindestens zwei Referenzelemente, etwa vergleichsweise den Codeelementen, aufweist. Es können dies Referenz-Reflektoren bzw. Referenz-Resonatoren sein, z.B. als ein Start-Element und/oder als ein Stop-Element zusätzlich zu den beschriebenen Codeelementen. Diese Referenzelemente sind unabhängig vom Raster unabhängig vom Raster in bekannten Positionen, bzw. als Resonatoren mit bekannten Resonanzfrequenzen, auf dem Oberflächenwellen-Bauelement angeordnet. Durch Vergleich der gemessenen und ggfs. auch noch gemittelten Meßwerte dieser Referenzelemente mit ihren jeweils vorgegebenen bekannten Werten, z.B. Vergleich der gemessenen Zeit-/Frequenzdifferenz zwischen dem Start- und dem Stop-Element mit der konstruktiv vorgegeben bekannten Differenz und/oder Vergleich der Meßwerte der Positionen/Frequenzen von Start-Element und Stop-Element mit ihren jeweiligen bekannten tatsächlichen Positionen/Frequenzen, kann ein Skalierungsfaktor und/oder ein Offset-Wert abgeleitet werden, mit dem (mit denen) alle Zeit-/Frequenz-Meßwerte der Codeelemente korrigiert werden können. Auch hierbei ist es vorteilhaft, die Kalibrierung mehrmals durchzuführen bzw. eine Mittelung über jeweils mehrere Messungen auszuführen, bis sichergestellt ist, daß die damit erreichte (verringerte) Ungenauigkeit der Positions-VZeit- bzw. Frequenzwerte um ein bestimmtes Maß sogar kleiner ist als das/ein vorgegebene(s) Maß der Meßungenauigkeit δ.

Es kann die oben beschriebene Mittelung oder die voranstehende Kalibrierung oder es können auch vorteilhafterweise beide Maßnahmen als Weiterbildung der Erfindung ausgeführt werden.

Zur noch weiteren Erläuterung der Erfindung dient auch die nachfolgende Beschreibung zu den zugehörigen Figuren.
- Figur 1: zeigt ein Beispiel eines erfindungsgemäß ausgestalteten Oberflächenwellen-Bauelements mit Reflektoren.
- Figur 1a: zeigt das Bauelement im System der Funkabfrage.
- Figur 2: zeigt eine Darstellung, mit der die Definition des erfindungsgemäß definierten Positionenrasters ergänzend erläutert ist.
- Figur 3: zeigt ein Beispiel für zwei Oberflächenwellen-Bauelemente mit unterschiedliche Codes eines Codeumfangs mit jeweils gleich großer Anzahl Reflektoren als Codeelemente.
- Figur 4: zeigt in Aufsicht einen konstruktiven Aufbau eines erfindungsgemäß codierten Oberflächenwellen-Bauelements mit Resonatoren als Codeelemente.
- Figur 5: zeigt ein erfindungsgemäß definiertes Frequenzen-Raster mit seinen einzelnen zur (eingeschränkten) Auswahl zur Verfügung stehenden Resonanzfrequenzen und
- Figur 6: zeigt ein Beispiel für zwei unterschiedliche Codes im Frequenzen-Raster.

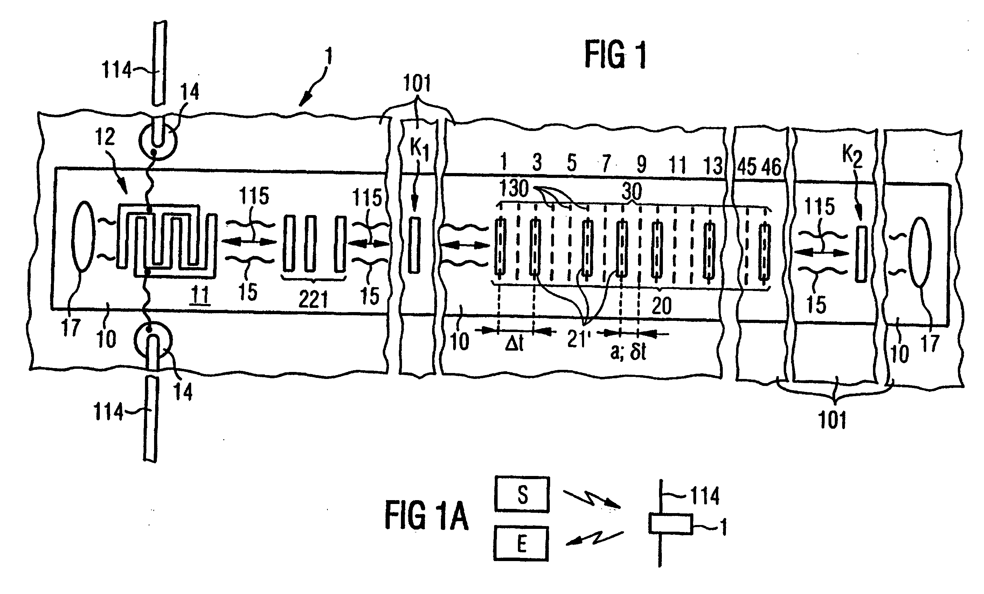

Die Figur 1 zeigt das Beispiel eines die erfindungsgemäße Lehre umfassenden Oberflächenwellen-Bauelements 1 mit einem Substratplättchen 10 aus z.B. Lithiumniobat, Lithiumtantalat und dgl. oder auch aus Quarz. Diese Materialien haben die erforderliche piezoelektrische Eigenschaft. Auf der in der Aufsicht dargestellten Oberfläche 11 des Substratplättchens 10 ist zum einen ein elektroakustischer Wandler 12 angeordnet. Dieser ist z.B. eine zwei kammartige Strukturen umfassende Interdigitalstruktur mit zwei elektrischen Anschlüssen 14. Diese sind als sogenannte Pads auf einer Trägerunterlage 101 des Substratplättchens 10 positioniert und mit der jeweiligen kammartigen Struktur elektrisch verbunden. An diese Anschlüsse 14 ist die für ein funkabfragbares Bauelement vorzusehende (Dipol-)Antenne 114 elektrisch anzuschließen. Mit 15 ist jeweils die mittels des Wandler 12 piezoelektrisch in der Oberfläche des Substratplättchens 10 zu erzeugende (symbolisch angedeutet) Oberflächenwelle bezeichnet. Mit dem Doppelpfeil 115 ist die Ausrichtung der Haupt-Wellenausbreitungsrichtung angegeben. Mit 20 ist zusammenfassend die Codeelemente-Struktur bezeichnet, die entsprechend der Wellenausbreitungsrichtung 115 ausgerichtet positionierte Codeelemente 21 umfaßt. Mit den Ziffern 1, 2, 3 ... 46 sind noch weiter unten näher zu beschreibende "Grundwerte" des Rasters numerativ benannt. Von diesen sind die Positionen 1 3, 6, 8, 10, 13 .... und 46 mit jeweils einem Codeelement 21 besetzt. In der Figur 1 sind hierfür Reflektoren 21' angegeben. Die für ein jeweiliges Oberflächenwellen-Bauelement einer Gruppe solcher Bauelemente individuell ausgewählte Verteilung dieser Codeelemente über die beispielsweise 46 Grundwerte entspricht einem bzw. bildet einen individuellen Code innerhalb des vorgegebenen Codeumfangs, der mit dieser Gruppe der Bauelemente bereitgestellt werden kann.

Für die oben beschriebene, besondere Durchführung des Auslesens mit Kalibrierung zur Beseitigung möglicher systematischer Fehler dienen als Referenzelemente die Reflektoren K₁ und K₂ als Start- und als Stop-Referenz-Codeelement.

Der Vollständigkeit halber sei noch auf weitere Strukturelemente hingewiesen, wie z.B. die Reflektoren, die in an sich bekannter Weise zu einer Sensorstruktur 221 gehören, die z.B. der Temperaturmessung, einer Kraftmessung oder dgl. dient. Mit 17 sind übliche Wellensümpfe für die Oberflächenwelle bezeichnet.

Die Figur 1a zeigt eine Übersicht des Systems, das das Oberflächenwellen-Bauelement 1 und den für das Funkabfragen erforderlichen Sender S und Empfänger E umfaßt.

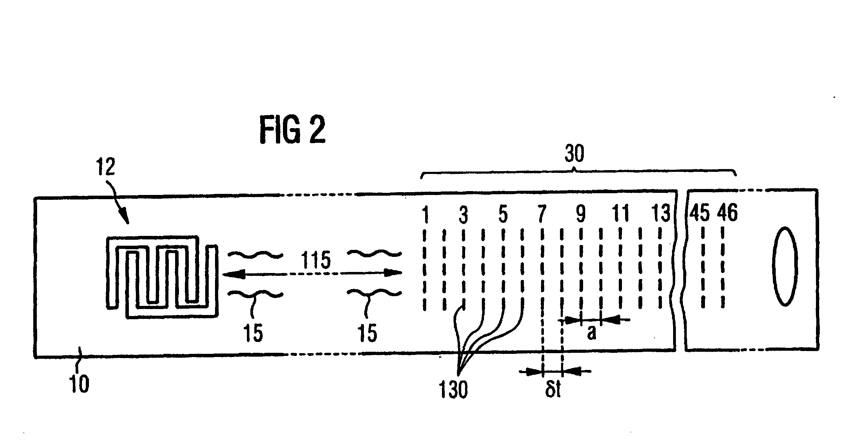

Die Figur 2 zeigt von der Ansicht des Ausführungsbeispiels der Figur 1 nur das Substratplättchen 10 und die Interdigitalstruktur 12 des Wandlers (weil diese die Haupt-Wellenausbreitungsrichtung 115 in der Oberfläche des Substratplättchens 10 bestimmt). Anstelle der (hier noch nicht ausgeführten) Codeelemente-Struktur 20 der Figur 1 ist das erfindungsgemäße, für die Erfindung für Reflektoren definierte Positionenraster 30 mit seinen Positionen-Grundwerten 130 angegeben, die wie in Figur 1 mit 1, 2, 3 .... bis 46 benannt sind. Die einzelnen Grundwerte 130 sind durch jeweils eine (Mittel-)Linie derselben dargestellt. Dieses erfindungsgemäße Raster 30 ist so definiert, daß es zum einen in der Haupt-Wellenausbreitungsrichtung 115 der mit dem Wandler 12 erzeugten Welle 15 ausgerichtet ist. Wegen der hier geradlinigen Wellenausbreitungsrichtung ist das Positionenraster 30 ein lineares Raster. In Sonderfällen kann auch eine andere Konfiguration vorliegen, jedoch folgt stets das Raster derart der Wellenausbreitung, so daß Reflektoren als Codeelemente auf den besetzten Positionen der Grundwerte 130 in wie an sich bekannter Weise reflektierend auf die Oberflächenwelle 15 einwirken können.

Das lineare Raster 30 hat so viele Grundwerte 130, wie dies der vorgegebene Codeumfang unter Berücksichtigung einer weiteren erfindungsgemäßen Verteilungsbedingung für die einzelnen Codeelemente erfordert. Der mit der Erfindung gegebenen Definition entsprechend sind die äquidistanten Abstände a der Grundwerte 130 voneinander so bemessen, daß das Maß.des jeweiligen Abstandes benachbarter Grundwerte (1 und 2, 2 und 3, ....) gleich der Wegstrecke δt ist, die die akustische Oberflächenwelle 15 innerhalb eines definierten Zeitmaßes zurücklegt. Dieses Zeitmaß ist für Laufzeitmessung mit Reflektoren als Codeelemente die oben definierte zeitlich bemessene bzw.durch eine Zeitangabe bestimmte Meßungenauigkeit δ des Systems, in dem das Oberflächenwellen-Bauelement 1 zusammen mit Sender S und Empfänger E enthalten ist.

Wie mit der Lehre der Erfindung vorgeschrieben, dürfen die Grundwerte 130 des Positionenrasters 30 nur in der Strukturauflösung entsprechenden Abständen Δt mit je einem Codeelement besetzt sein. Bei δt ≤ ½ Δt sind ein oder mehrere Grundwerte 130 zwischen zwei mit Codeelementen besetzten Grundwerten 130 freigehalten.

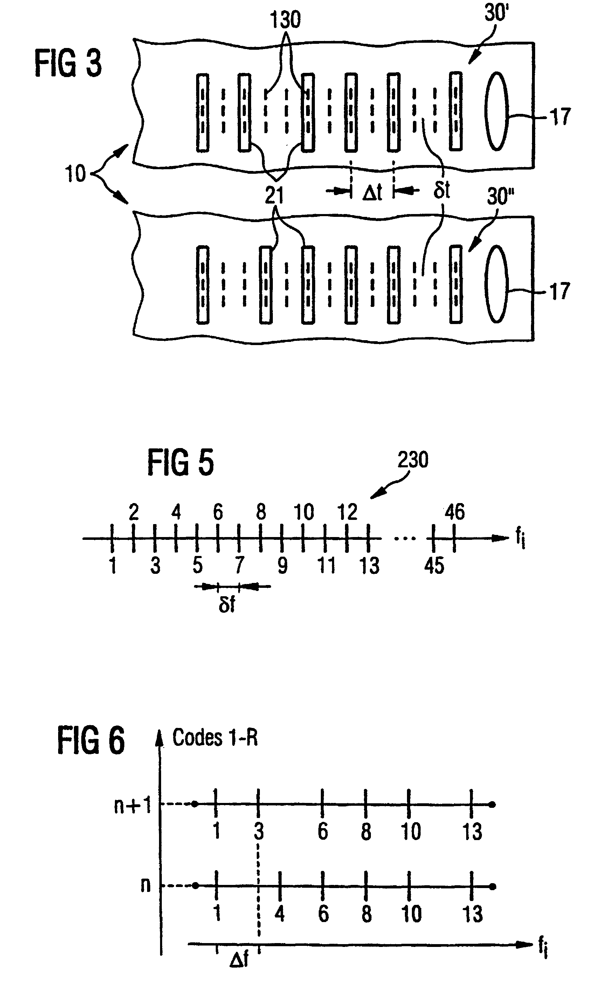

Als ein veranschaulichendes Beispiel zum Anspruch 3 zeigt die Figur 3 nebeneinander dargestellt zwei Positionenraster 30' und 30'' mit (vereinfacht nur) je 13 Raster-Grundwerte 130. Von diesen sind in beiden Rastern vorzugsweise jeweils gleich viele, nämlich je sechs Grundwerte 130 mit Codeelementen 21, d.h. mit Reflektoren 21', besetzte Positionen des jeweiligen Rasters. Die Besetzungsverteilung ist jedoch entsprechend dem unterschiedlichen Code in beiden Rastern verschieden.

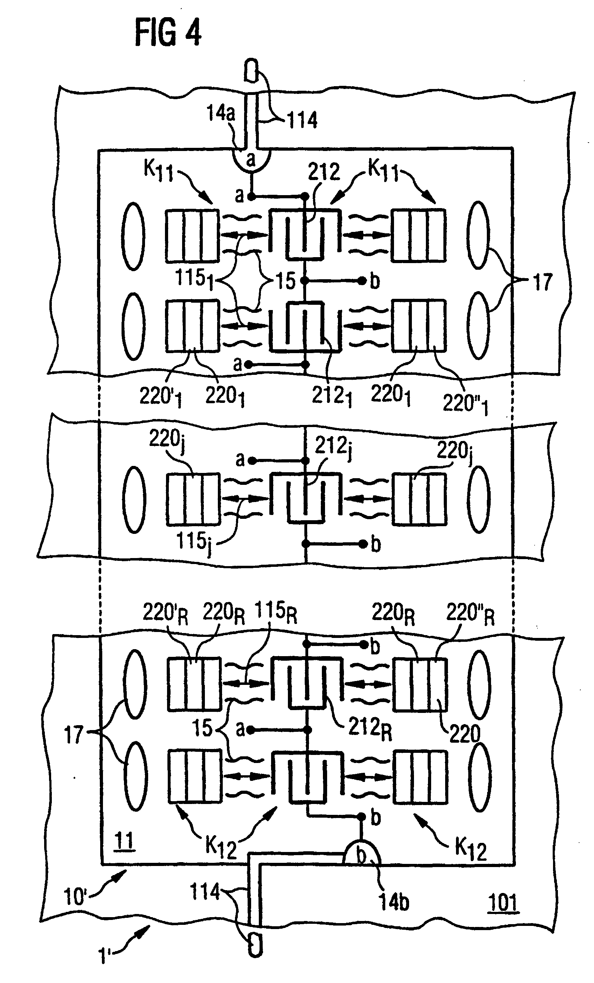

Die Figur 4 zeigt als Beispiel eine Ausführungsform mit Resonatoren anstelle von wie in den voranstehenden Figuren gezeigten Reflektoren.

Die Figur 4 zeigt in Aufsicht ein Oberflächenwellen-Bauelement 1' mit Resonatoren 220. Mit 10' ist das Substratplättchen bezeichnet, auf dessen Oberfläche 11 Wandler 212, die erwähnten Resonatoren 220, Anschlüsse 14 für die Dipolantenne 114 und Wellensümpfe 17 zur Wellendämpfung angeordnet sind. In der zweiten Zeile der Figur 4 sind ein Wandler 212₁ und die einen Resonator 220₁ bildenden zwei Resonatorenanteile 220₁' und 220₁'' gezeigt. Mit 115 ist die Hauptwelienausbreitungsrichtung und mit 15 die zugehörige Oberflächenwelle angedeutet. Der Resonator 220₁ besteht in seinen beiden Anteilen aus für ein solches Element üblichen, voneinander beabstandeten Reflektorstreifen und ist durch Wahl des Streifenabstandes auf z.B. die ausgewählte Frequenz f₁ abgestimmt. Dieser Resonator 220₁ ist ein erstes Codeelement dieses in Figur 4 gezeigten codierten Bauelements 1'. Ein j-tes Codeelement zeigt die darunterliegende Zeile mit dem aus wieder zwei Anteilen bestehenden Resonator 220ⱼ und seinem für die Erzeugung der Welle 15 erforderlichen Wandler 212ⱼ. Auch die Frequenz fⱼ ist aus dem erfindungsgemäßen Frequenzen-Raster ausgewählt. Das R-te Codeelement des Bauelements 1' zeigt die vierte Zeile. Wiederum besteht der Resonator aus zwei Anteilen 220_{R}. Der Resonator 220_{R} ist auf die Frequenz f_{R} abgestimmt, die ebenfalls im vorgegebenen erfindungsgemäßen Frequenzen-Raster ausgewählt ist. Diese Resonatoren sind also bezüglich ihrer Resonanzfrequenz in an sich bekannter Weise abgestimmte Oberflächenwellen-Strukturen mit den voneinander verschiedenen Frequenzen f₁ bis f_{R}. Diese ausgewählten Frequenzen ergeben den Gesamtcode des individuellen Oberflächenwellen-Bauelements. Die Wandler 212₁ bis 212_{R} können in wie angegebener Weise in Serie geschaltet oder auch parallelgeschaltet sein. Es kann auch ein konstruktiv einziger Wandleraufbau vorgesehen sein, der jedoch die dargestellten Hauptwellenausbreitungsrichtungen 115₁ bis 115_{R} umfaßt. Regelmäßig ist die Bandbreite eines solchen Wandlers 212 so groß, daß auch identisch ausgeführte Wandler die Wandler-Kette bilden können.

Das für die Ausführungsform mit Resonatoren relevante erfindungsgemäße Frequenzen-Raster 230 der Figur 5 ist ein Analogon zum Positionenraster der Figur 2. Der anspruchsgemäß für die Erfindung relevante Rasterabstand δf im Frequenzbereich ist durch die Meßungenauigkeit des Systems, bestehend aus Sender, Empfänger und Bauelement, oder durch die mit Mehrfach-Messungen bzw. mit Mittelung erreichbare Meßungenauigkeit gegeben, vergleichsweise dem durch die zeitliche Meßungenauigkeit gegebenen Abstand der Grundwerte 130 in Figur 2. In Anlehnung an die Ausführungsformen der Figuren 1 und 2 sind auch in Figur 5 beispielsweise 46 Frequenzen fᵢ angegeben. Wieviele solcher Frequenzen fᵢ für ein Bauelement 1' zur Auswahl der Anzahl R Resonanzfrequenzen seiner Resonatoren 220₁ bis 220_{R} notwendig sind, richtet sich auch hier nach dem vorgegebenen Codeumfang. (Um ein Bauelement 1 bzw. 1' nach Figur 1 bzw. nach Figur 4 geometrisch möglichst klein halten zu können, wird man auch hier die Anzahl R minimal groß wählen, was mit der Erfindung mit verringerter Meßungenauigkeit δ bei z.B. unverändert grober Strukturauflösung Δ zu erreichen ist.)

Anspruchsgemäß gilt für die "Besetzung" der möglichen Grundwerte des Frequenzen-Rasters nach Figur 5 die Beschränkung, daß zwischen zwei benachbarten, für Resonatoren verwendeten Frequenzen fⱼ und fⱼ₊₁ (j = von 1 bis R) der Frequenzabstand Δf betragen muß, wobei Δf wenigstens gleich groß wie die durch die Güte des Systems gegebene Strukturauflösung ist. Diese Strukturauflösung ist der Frequenzabstand Δf, der notwendig ist, um zwei voneinander verschiedene Resonanzfrequenzen im System voneinander unterscheiden zu können. Zum Beispiel kann verglichen mit dem oben beschriebenen Bauelement 1 mit Reflektoren mit einem minimal zulässigen Positionenabstand entsprechend der zeitlichen Größe Δt bei einer Ausführungsform mit Resonatoren eine Besetzung der Frequenzpositionen f₁ bis f₄₆ des Rasters nach Figur 5 mit einem minimalen Frequenzabstand Δf = 2 x δf genutzt werden, wenn die Frequenz-Meßungenauigkeit des Systems zweifach kleiner ist als die frequenzmäßige Strukturauflösung Δf.

Für die Durchführung des Auslesens mit Kalibrierung dienen beim Bauelement mit Resonatoren als Referenzelemente die Resonatoren K₁₁ und K₁₂ als Start- und als Stop-Elemente.

Figur 6 zeigt vergleichsweise zur Figur 3 das Frequenzenschema zweier verschiedener Codes aus einem vorgegebenen Codeumfang mit vorgegeben sechs Resonatoren als Codeelemente des Codes. Zum Beispiel sind dies die verschiedenen Codes der Bauelemente 1(n) und 1(n+1) einer Anzahl N codierter Oberflächenwellen-Bauelemente 1' eines vorgegebenen Codeumfangs.

Mit der Anwendung der Erfindung erzielt man auch Vorteile, die sich hinsichtlich der Ausführung des Herstellungsprozesses ergeben. Zum Beispiel kann bei der Herstellung eines erfindungsgemäß codierten Bauelements die Belichtungszeit für die Herstellung der Codeelemente (Reflektoren/Resonatoren) verringert, z.B. halbiert, werden. Dies, indem auf der Belichtungsmaske immer zwei z.B. Reflektoren gemeinsam plaziert sind, die gemeinsam belichtet werden. Diese beiden Reflektoren müssen hierzu mit voneinander unterschiedlichen Abständen, und zwar in Mindestabständen gemäß der erfindungsgemäßen Vorschrift auf der Belichtungsmaske vorgesehen sein. Beträgt beispielsweise die Strukturauflösung 1 µs und die Anzahl der Codeelemente P = 4 pro Intervall Δ der Strukturauflösung, so müssen Belichtungsmasken mit jeweils zwei gleichzeitig zu belichtenden Reflektoren für die Reflektorabstände 1,00, 1,25, 1,50, 1,75 und ggfs. noch 2,00 µs vorgesehen werden.

## Patentansprüche

1. Codiertes Oberflächenwellen-Bauelement (1), vorgesehen für ein ID-Tag-Funkabfrage-System (S, E, 1),
mit einem Substratplättchen (10) mit in dessen Oberfläche (11) piezoelektrischer Materialeigenschaft,
mit wenigstens einem elektroakustischen Wandler (12), der eine auf der Oberfläche (11) des Substratplättchens (10) befindliche Interdigitalstruktur umfaßt, die zur Erzeugung einer akustischen Oberflächenwelle (15) mit einer durch diese Struktur bestimmten Haupt-Wellenausbreitungsrichtung (115) in der Oberfläche (11) dient, und
mit einer Reflektor-Struktur (20), die jeweilige Reflektoren (21') als Codeelemente (21) umfaßt, die in dieser Haupt-Wellenausbreitungsrichtung (115) auf dieser Oberfläche (11) des Substratplättchens (10) voneinander beabstandet sind,
**gekennzeichnet dadurch,**
**daß** für die abstandsmäßige Positionierung der Reflektoren (21') ein Positionenraster (30') mit äquidistant voneinander beabstandeten Grundwerten (130) ausgewählt ist, das in der Haupt-Wellenausbreitungsrichtung (115) ausgerichtet ist und
bei dem das Maß des Raster-Abstandes (δt) bemessen ist nach der Wegstrecke, die die akustische Oberflächenwelle (15) innerhalb der durch die zeitliche bemessene Meßungenauigkeit (δ) des Systems (S, E, 1) vorgegebenen Zeitdauer (0,5, 0,33 ... µs) zurücklegt und
**daß** von diesen Grundwerten (130) dieses Positionenrasters (30) nur solche als Positionen dem jeweiligen Code entsprechend verteilt mit Reflektoren besetzt sind, bei denen die Abstände zwischen benachbarten Reflektoren stets wenigstens gleich groß wie die durch die Frequenzbandbreite des Systems gegebenen Strukturauflösung (Δt) (1 µs) ist.

2. Codiertes Oberflächenwellen-Bauelement (1'), vorgesehen für ein ID-Tag-Funkabfrage-System (S, E, 1'),
mit einem Substratplättchen (10) mit in dessen Oberfläche (11) piezoelektrischer Materialeigenschaft,
mit einem oder mehreren elektroakustischen Wandlern (212) mit Interdigitalstruktur(en), angeordnet auf der Oberfläche (11) des Substratplättchens (10), die zur Erzeugung akustischer Oberflächenwellen (15) mit jeweiligen durch diese Struktur bestimmten Haupt-Wellenausbreitungsrichtungen (115) in der Oberfläche (11) dienen, und
mit als Codeelemente vorgesehenen Resonatorstrukturen (220ⱼ) mit jeweiliger Resonanzfrequenz (fⱼ) derselben, wobei diese Resonatorstrukturen, jede bezogen auf den jeweiligen Wandler, in der jeweiligen Haupt-Wellenausbreitungsrichtung desselben angeordnet sind,
**gekennzeichnet dadurch,**
**daß** für die Bestimmung der einzelnen Resonanzfrequenzen (fⱼ) der Resonatorstrukturen (220) ein Frequenzen-Raster (230) mit äquidistant voneinander beabstandeten Frequenzen (f₁ ... f₄₆)als Grundwerten des Rasters ausgewählt ist,
wobei das Maß des Frequenzabstandes (δf) dieser Grundwerte voneinander innerhalb des Frequenzen-Rasters (230) bemessen ist nach der Meßungenauigkeit (δf), mit der in dem System eine Frequenz gemessen werden kann, und
in diesem Frequenzen-Raster (230) die Resonanzfrequenzen (fⱼ) für die jeweilige der Resonatorstrukturen (230ⱼ) so ausgewählt sind, daß innerhalb dieses Frequenzen-Rasters (230) nur solche Resonanzfrequenzen für die einzelnen Resonatorstrukturen (220) benutzt sind, daß zwischen zwei benachbarten Resonanzfrequenzen (fⱼ;fⱼ₊₁) vorgesehener Resonatorstrukturen (220) der jeweilige Frequenzabstand (Δf) wenigstens gleich groß wie die durch die Resonanzdauer des einzelnen Resonators im System gegebenen Strukturauflösung (Δf)der Frequenzmessung ist.

3. Bauelement nach Anspruch 1 oder 2,
bei dem innerhalb des vorgegebenen Codeumfangs den einzelnen Codes jeweils eine gleich große Anzahl Codeelemente (21) zugeordnet sind. (Figur 3)

4. Bauelement nach einem der Ansprüche 1 oder 3,
bei dem das Substratpiättchen (10) in Richtung des Positionenrasters (30) eine durch die Interdigitalstruktur des Wandlers (12) und die mit dem vorgegebenen Codeumfang hinsichtlich des Positionenrasters (30) gegeben minimale Baulänge hat.

5. Bauelement nach einem der Ansprüche 1 bis 4,
mit sätzlich wenigstens einer Sensorstruktur (221).

6. Bauelement nach einem der Ansprüche 1 bis 5,
mit zur Erweiterung des Codeumfangs zusätzlicher Wichtung der Codeelemente.

7. Bauelement nach einem der Ansprüche 1 bis 6,
mit zu den Codeelementen (21;220) zusätzlichen Referenzelementen (K₁, K₂; K₁₁, K₁₂ ).

8. Verfahren zur Bestimmung eines jeweiligen Codes eines Bauelementes nach einem der Ansprüche 1 bis 6,
**gekennzeichnet dadurch,**
**daß** die Antwortsignale der einzelnen Codeelemente (21; 220) des jeweiligen Codes (20; 220₁ bis 220_{R}) jeweils mehrfach aufeinanderfolgend erfaßt werden und aus den erfaßten Werten für ein jedes Codeelement (21; 220) der gemittelte Wert gebildet wird und/oder aus Werten der Codeelemente des Codes ein Maß bestimmt wird, das die Meßungenauigkeit (δ) repräsentiert.

9. Verfahren nach Anspruch 8,
wobei das Maß, das die Meßungenauigkeit (δ) repräsentiert, das Maß der mittleren Abweichung der Meßwerte eines jeden Codeelements von seinem Mittelwert (= statistische Standardabweichung) ist.

10. Verfahren nach Anspruch 8 oder 9,
bei dem das Erfassen der Antwortsignale der einzelnen Codeelemente derart vielfach ausgeführt wird, daß die ermittelte mittlere Meßungenauigkeit (δ_{M}) aller gemittelten Werte auf ein solches Maß verringert ist, daß es ein vorgegebenes Maß der Meßungenauigkeit (δ) unterschreitet, anhand dessen das Rastermaß (δ) des Oberflächenwellen-Bauelements gebildet ist.

11. Verfahren nach Anspruch 9 oder 10,
bei dem das Erfassen der Antwortsignale der einzelnen Codeelemente derart vielfach ausgeführt wird, daß die ermittelte mittlere Meßungenauigkeit (δ_{M}) eines repräsentativen Mittelwertes auf ein solches Maß verringert ist, daß es das vorgegebene Maß der Meßungenauigkeit (δ) unterschreitet, anhand dessen das Rastermaß (δ) des Oberflächenwellen-Bauelements gebildet ist.

12. Verfahren nach einem der Ansprüche 8 bis 11 zur Durchführung des Bestimmens eines jeweiligen Codes eines Oberflächenwellen-Bauelements mit Referenzelementen nach Anspruch 7,
**gekennzeichnet dadurch,**
**daß** die Referenzelemente (K₁, K₂; K₁₁, K₁₂ ) mehrmals aufeinanderfolgend abgefragt werden und aus den mehrmals erhaltenen Antwortsignalen gemittelte Skalierungs- und/oder Offset-Werte bestimmt werden und
**daß** mit diesen gemittelten Werten die Antwortsignale der Codeelemente korrigiert werden.

13. Verfahren, bei dem die Maßnahmen der Patentansprüche 8 oder 9 oder 10 zusammen mit Maßnahmen des Anspruches 11 durchgeführt werden.

## Claims

1. Coded surface acoustic wave component (1), intended for an ID tag radio interrogation system (S, E, 1),
having a substrate wafer (10) whose surface (11) has a piezoelectric material characteristic,
having at least one electroacoustic transducer (12) which has an interdigital structure which is located on the surface (11) of the substrate wafer (10) and is used for producing a surface acoustic wave (15) in the surface (11) with a main wave propagation direction (115) governed by this structure, and
having a reflector structure (20) which has respective reflectors (21') as code elements (21), which are spaced apart from one another in this main wave propagation direction (115) on this surface (11) of the substrate wafer (10),
**characterized**
**in that** a position matrix (30') is selected for positioning the reflectors (21') at the correct distances apart, has basic values (130) at equal distances from one another, and is aligned in the main wave propagation direction (115), and
in which the size of the matrix spacing (δt) is dimensioned on the basis of the movement distance which the surface acoustic wave (15) travels within the time period (0.5, 0.33 ... µs) predetermined by the time-dimensioned measurement inaccuracy (δ) of the system (S, E, 1) and
**in that**, of these basic values (130) of this position matrix (30), the only basic values (130) which are occupied with reflectors as positions distributed corresponding to the respective code are those for which the distances between adjacent reflectors are always at least of equal magnitude to the structure resolution (Δt) (1 µs) resulting from the frequency bandwidth of the system.

2. Coded surface acoustic wave component (1'), intended for an ID tag radio interrogation system (S, E, 1'), having a substrate wafer (10) whose surface (11) has a piezoelectric material characteristic,
having one or more electroacoustic transducers (212) with an interdigital structure or structures, arranged on the surface (11) of the substrate wafer (10), which are used for producing a surface acoustic waves (15) in the surface (11) with respective main wave propagation directions (115) governed by this structure, and
having resonator structures (220ⱼ) which are provided as code elements and each have a resonant frequency (fⱼ) thereof, with these resonator structures, each with respect to the respective transducer, being arranged in the respective main wave propagation direction thereof,
**characterized**
**in that**, in order to determine the individual resonant frequencies (fⱼ) of the resonator structures (220), a frequency matrix (230) is selected having frequencies (f₁ ... f₄₆) at equal intervals from one another as basic values of the matrix,
with the size of the frequency interval (δf) between these basic values within the frequency matrix (230) being dimensioned on the basis of the measurement inaccuracy (δf) with which a frequency can be measured in the system, and
in this frequency matrix (230), the resonant frequencies (fⱼ) for each of the resonator structures (230ⱼ) being selected such that, within this frequency matrix (230), the only resonant frequencies which are used for the individual resonator structures (220) are those such that the respective frequency separation (Δf) between two resonator structures (220) provided for adjacent resonant frequencies (fⱼ;fⱼ₊₁) is at least of equal magnitude to the structure resolution (Δf) of the frequency measurement resulting from the resonance duration of the individual resonator in the system.

3. Component according to Claim 1 or 2, in which, within the predetermined code size, an equal number of code elements (21) are in each case assigned to the individual codes. (Figure 3).

4. Component according to one of Claims 1 or 3, in which the substrate wafer (10) has a minimum physical length in the direction of the position matrix (30) resulting from the interdigital structure of the transducer (12) and the minimum physical length with the predetermined code size with regard to the position matrix (30).

5. Component according_to one of Claims 1 to 4, additionally having at least one sensor structure (221).

6. Component according to one of Claims 1 to 5, having additional weighting of the code elements in order to enlarge the code size.

7. Component according to one of Claims 1 to 6, having reference elements (K₁, K₂; K₁₁, K₁₂) in addition to the code elements (21; 220).

8. Method for determining a respective code of a component according to one of Claims 1 to 6,
**characterized**
**in that** the response signals of the individual code elements (21; 220) of the respective code (20; 220₁ to 220_{R}) are each detected a number of times successively, and the average value is formed from the detected values for each code element (21; 220), and/or a measure which represents the measurement inaccuracy (δ) is determined from values of the code elements of the code.

9. Method according to Claim 8,
where the measure which represents the measurement inaccuracy (δ) is the measure of the mean deviation between the measured values of each code element and its mean value (= statistical standard deviation).

10. Method according to Claim 8 or 9,
in which the response signals of the individual code elements are detected a large number of times in such a manner that the determined mean measurement inaccuracy (δ_{M}) of all the averaged values is reduced to a measure such that this measure is less than a predetermined measure of the measurement inaccuracy (δ) on the basis of which the matrix size (δ) of the surface acoustic wave component is formed.

11. Method according to Claim 9 or 10,
in which the response signals of the individual code elements are detected a large number of times in such a manner that the determined_mean measurement inaccuracy (δ_{M}) of a representative mean value is reduced to a measure such that this measure is less than the predetermined measure of the measurement inaccuracy (δ) on the basis of which the matrix size (δ) of the surface acoustic wave component is formed.

12. Method according to one of Claims 8 to 11, for carrying out the determination of a respective code of a surface acoustic wave component having reference elements according to Claim 7,
**characterized**
**in that** the reference elements (K₁, K₂; K₁₁, K₁₂) are interrogated a number of times successively and averaged scaling and/or offset values are determined from the response signals obtained a number of times, and
**in that** the response signals of the code elements are corrected using these averaged values.

13. Method, in which the measures in Patent Claims 8 or 9 or 10 are carried out together with the measures in Claim 11.

## Revendications

1. Composant à ondes de surface codé (1), prévu pour un système d'interrogation à distance à étiquette d'identification (S, E, 1), comprenant une plaquette de substrat (10) dotée à sa surface (11) d'une propriété matérielle piézoélectrique,
au moins un transducteur électroacoustique (12), qui comprend une structure interdigitale se trouvant à la surface (11) de la plaquette de substrat (10), qui sert à générer une onde de surface acoustique (15) avec une direction de propagation de l'onde principale (115) déterminée par cette structure à la surface (11), et
une structure à réflecteur (20), qui comprend des réflecteurs (21') respectifs comme éléments de code (21), espacés les uns des autres sur cette surface (11) de la plaquette de substrat (10) dans cette direction de propagation de l'onde principale (115),
**caractérisé en ce que** pour le positionnement espacé des réflecteurs (21') une grille de positions (30') comprenant des valeurs de base espacées les unes des autres de manière équidistante (130), est sélectionnée, laquelle est orientée dans la direction de propagation de l'onde principale (115) et
dans laquelle le degré d'espacement de la grille (δt) est dimensionné en fonction de la distance accomplie par l'onde de surface acoustique (15) pendant la période (0,5, 0,33... µs) prédéfinie par l'imprécision de mesure (δ) du système (S, E, 1) mesurée dans le temps et **en ce que** parmi ces valeurs de base (130) de cette grille de positions (30) seules sont occupées comme positions réparties avec des réflecteurs conformément au code correspondant, les valeurs dont les écarts entre des réflecteurs voisins sont toujours au moins aussi grands que la
résolution structurelle (Δt) (1 µs) donnée par la largeur de bande de fréquence du système.

2. Composant à ondes de surface codé (1') prévu pour un système d'interrogation à distance à étiquette d'identification (S, E, 1), comprenant une plaquette de substrat (10) dotée à sa surface (11) d'une
propriété matérielle piézoélectrique,
au moins un transducteur électroacoustique (12), qui comprend une à plusieurs structure(s) interdigitale(s) se trouvant à la surface (11) de la plaquette de substrat (10), qui sert à générer des ondes de surface acoustiques (15) avec des directions de propagation de l'onde principale (115) déterminées par cette structure à la surface (11), et
des structures à résonateurs prévues comme éléments de code (220ⱼ), à fréquence de résonance respective (fj) de ces mêmes structures, ces structures de résonance, chacune rapportée au transducteur respectif, étant disposées dans la direction de propagation de l'onde principale respective de ce même transducteur,
**caractérisé en ce que** pour déterminer les fréquences de résonance (fⱼ) individuelles des structures à résonateurs (220) une grille de fréquence (230) comprenant des fréquences (f₁...f₄₆) espacées de manière équidistante les unes des autres comme valeurs de base de la grille est sélectionnée, le degré d'écartement des fréquences (δf), de ces valeurs de base les unes par rapport aux autres à l'intérieur de la grille de fréquences (230) étant dimensionné en fonction de l'imprécision de mesure (δf), avec laquelle une fréquence peut être mesurée dans le système, et dans cette grille de fréquences (230) les fréquences de résonance (fⱼ) pour les structures à résonateurs respectives (230) étant choisies de telle manière qu'à l'intérieur de la grille de fréquences (230), seules les fréquences de résonance sont utilisées pour les structures à résonateurs (220) individuelles, de telle sorte qu'entre deux fréquences de résonance (fⱼ ; fⱼ₊₁) voisines de deux structures à résonateurs prévues (220), l'écart de fréquence respectif (Δf) soit au moins égal à la résolution structurelle (Δf) de la mesure de fréquences déterminée par la durée de la résonance du résonateur individuel dans le système.

3. Composant selon la revendication 1 ou 2, dans lequel, à l'intérieur de l'écartement code prédéfini, un nombre égal d'éléments de code (21) est affecté au code individuel. (Figure 3)

4. Composant selon l'une des revendications 1 ou 3, dans lequel la plaquette de substrat (10) dans la direction de la grille de positions (30) présente une longueur de construction minimale donnée par la structure interdigitale du transducteur (12) et par l'écartement code prédéfini par rapport à la grille de positions (30).

5. Composant selon l'une des revendications 1 à 4, avec en principe au moins une structure à capteurs (221).

6. Composant selon l'une des revendications 1 à 5, comprenant une pondération supplémentaire des éléments du code pour l'extension de l'écartement code.

7. Composant selon l'une des revendications 1 à 6, avec des éléments de référence (K₁, K₂, K₁₁, K₁₂) en sus des éléments de code (21 ;220).

8. Procédé pour la détermination d'un code respectif d'un composant selon l'une des revendications 1 à 6, **caractérisé en ce que** les signaux réponse des éléments individuels de code (21 ; 220) du code respectif (20 ; 220₁ à 220_{R}) sont saisis successivement et respectivement à plusieurs reprises et **en ce que** à partir des valeurs saisies pour chaque élément du code (21 ; 220) la valeur moyenne est formée et/ou à partir des valeurs des éléments du code une dimension est déterminée qui représente l'imprécision de la mesure (δ).

9. Procédé selon la revendication 8, la dimension représentant l'imprécision de la mesure (δ) étant la dimension de l'écart moyen des valeurs de mesure d'un élément de code respectif par rapport à sa valeur moyenne (= écart statistique type).

10. Procédé selon la revendication 8 ou 9, dans lequel la saisie des signaux réponse des éléments individuels de code s'effectue d'une manière si multiple que l'imprécision de la mesure (δ) moyenne calculée de toutes les valeurs moyennes est ramenée à une dimension telle qu'elle reste inférieure à un degré prédéfini d'imprécision de la mesure (δ), à l'aide duquel la dimension de la grille (δ) du composant à ondes de surface est formée.

11. Procédé selon la revendication 9 ou 10, dans lequel la saisie des signaux réponse des éléments individuels du code s'effectue d'une manière si multiple que l'imprécision de la mesure (δ_{M}) moyenne calculée d'une valeur moyenne représentative est ramenée à un tel degré qu'elle reste inférieure à un degré prédéfini d'imprécision (δ) à l'aide duquel la dimension de la grille (δ) du composant à ondes de surface est formée.

12. Procédé selon l'une des revendications 8 à 11 pour exécuter la détermination d'un code respectif d'un composant à ondes de surface à éléments de référence selon la revendication 7, **caractérisé en ce que** les éléments de référence (K₁, K₂ ; K₁₁, K₁₂) sont interrogés successivement à plusieurs reprises et qu'à partir des signaux réponse obtenus plusieurs fois des valeurs d'échelle et/ou des valeurs de décalage sont déterminées et
**en ce que** avec ces valeurs moyennes les signaux réponse des éléments du code sont corrigés.

13. Procédé dans lequel les mesures visées aux revendications 8 ou 9 ou 10 sont effectuées conjointement avec les mesures visées à la revendication 11.
